Europäisches Patentamt

European Patent Office

Office européen des brevets

(11) Veröffentlichungsnummer: **0 182 889**
**B1**

(12) **EUROPÄISCHE PATENTSCHRIFT**

(45) Veröffentlichungstag der Patentschrift: 23.01.91

(21) Anmeldenummer: 85902985.2

(22) Anmeldetag: 07.06.85

(86) Internationale Anmeldenummer:
PCT/EP85/00275

(87) Internationale Veröffentlichungsnummer:
WO 86/00093 03.01.86 Gazette 86/01

(51) Int. Cl.$^5$: **C 23 C 16/26**

(54) **VERFAHREN ZUR HERSTELLUNG VON DIAMANTARTIGEN KOHLENSTOFFSCHICHTEN.**

(30) Priorität: 12.06.84 DE 3421739

(43) Veröffentlichungstag der Anmeldung:
04.06.86 Patentblatt 86/23

(45) Bekanntmachung des Hinweises auf die
Patenterteilung:
23.01.91 Patentblatt 91/04

(84) Benannte Vertragsstaaten:
AT BE CH DE FR GB IT LI LU NL SE

(56) Entgegenhaltungen:
DE-A-3 047 888     US-A-4 410 504
US-A-3 167 449     US-A-4 434 188

Thin Solid Films Vol. 58 (1979) Seiten 117-120
Journal of Appplied Physics, Band 54, Nr. 8,
August 1983, New York (US) - A. Bubenzer : "Rf
-plasma deposited amorphous hydrogenated
hard carbon thin films: preparation, properties,
and applications", Seiten 4590-4595, siehe Seite
4591, linke Spalte B

(73) Patentinhaber: Battelle-Institut e.V.
Am Römerhof 35 Postfach 900 160
D-6000 Frankfurt/Main 90 (DE)

(72) Erfinder: ETZKORN, Heinz-Werner
Schumannstrasse 16
D-6392 Neu-Anspach (DE)
Erfinder: RONGE, Werner
Moselstrasse 6
D-6082 Mörfelden/Walldorf (DE)

(74) Vertreter: Sartorius, Peter, Dipl.-Ing.
Battelle-Institut e.V. Abteilung Patente Am
Römerhof 35
D-6000 Frankfurt am Main 90 (DE)

(56) Entgegenhaltungen:
4ème Colloque International sur les plasmas et
la pulvérisation cathodique, C.I.P. 82, Nuc 13-17,
Septembre 1982; J.M.
Mackowski:"Comparaison physiochimique des
couches de carbone à large bande interdite (I-C)
élaborées par différentes techniques plasma",
Seiten 99-106

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

(56) Entgegenhaltungen:

Patents Abstracts of Japan, Band 4, Nr. 67, 20
Mai 1980, Seite 103E11; & JP-A-
5536980(MATSUSHITA), 14. März 1980

**Beschreibung**

Die Erfindung betrifft ein Verfahren zur Herstellung einer diamantartigen Kohlenstoffschicht, bei dem ein Arbeitsgas, enthaltend ein Kohlenwasserstoffgas oder eine Mischung von Kohlenwasserstoffgasen, ggf. in Anwesenheit eines Edelgases, durch eine bei niedriger Spannung brennende Plasmaentladung ionisiert wird, die durch eine Hochfrequenzanregung erzeugt wird, die von den zugeleiteten Gasen selbst getragen wird, wobei die Gase in der Plasmaentladung angeregt, dissoziiert, ionisiert und auf ein zu beschichtendes Substrat beschleunigt werden, wobei das Substrat höchstens auf Raumtemperatur gehalten wird.

Diamantartige Kohlenstoffschichten werden insbesondere zur Vergütung von IR-Optiken, z.B. Linsen, Spiegel oder dergleichen eingesetzt. Die Beschichtung solcher Objekte erfolgt unter Vakuumbedingungen, wobei ein Gasgemisch aus Kohlenwasserstoffen, z.B. Acetylen, und einem Edelgas, z.B. Argon, einer Plasmaentladung ausgesetzt wird. Die nach dem Stand der Technik so hergestellten Schichten sind im sichtbaren Wellenlängenbereich nicht transparent und von gelber, bräunlicher, blauer oder schwarzer Farbe. Aus diesem Grunde können diese Schichten nicht als Kratzschicht für Optiken im sichtbaren Spektralbereich eingesetzt werden, sondern nur für den IR-Wellenbereich.

Aus der GB-A-2 128 637 ist ein Verfahren zur Abscheidung eines diamantartigen Kohlenstoff-Films bekannt, bei dem Kohlenstoff- und andere Ionen in jeweils separaten feststehenden Quellen erzeugt, auf eine Oberfläche des zu beschichtenden Substrats gerichtet und beschleunigt werden. Die Funktion der zweiten Ionenart besteht darin, durch ein sogenanntes chemisches Sputtern die unerwünschten Kohlenstoff-formen aus dem gebildeten Firm zu beseitigen. Zu diesem Zweck wird unter anderem auch Wasserstoff verwendet. Das Substrat wird auf eine Temperatur von 100 bis 200°C erwärmt. Auf diese Weise werden gelb bis braun gefärbte Schichten erhalten, die sich ebenfalls für IR-Optiken eignen.

Bei den konventionellen Methoden, die feste Quellen verwenden, muß das Substrat zur Erzielung einer allseitigen Beschichtung relativ zu den Quellen gedreht werden. Eine gleichzeitige Beschichtung größerer Stückzahlen ist technisch möglich, aber sehr aufwendig. Ein weiterer Nachteil besteht darin, daß eine relativ geringe Aufwachsrate von typisch 0,1 bis 1 µm pro Stunde erreicht werden kann. Außerdem können nur vergleichsweise dünne Schichten erzeugt werden, weil die internen Spannungen in den diamantartigen Kohlenstoffschichten bei Schichtdicken von mehr als etwa 1 µm zum Zerreißen der Schicht führt. Daraus resultiert, daß für die Anwendung als Hartstoffbeschichtung nur eine sehr geringe Verschleißreserve vorhanden ist und damit der Einsatz der beschichteten Substrate begrenzt ist, wenn Möglichkeiten in Betracht gezogen werden, die solche Schichten abdecken könnten, wenn sie dicker herstellbar wären.

Die DE-A-30 47 888 beschreibt ein Verfahren mit den eingangs genannten Merkmalen. Dort wird in einem Druckbereich von $10^{-2}$ bis $10^{-3}$ Pa abgeschieden und an das Substrat wird eine Vorspannung von etwa 100 V angelegt. Nach dem dort geschriebenen Verfahren sollen Beschichtungen von 10 nm bis zu 10 µm hergestellt werden können. Aussagen über die Transparenz der Schichten werden dort nicht getroffen.

Die US-A-4,434,188 beschreibt die Abscheidung diamantartiger Kohlenstoffschichten aus dem Plasma mit Kohlenwasserstoffen und Wasserstoff als Reaktionsgasen. Es wird dort auf Nachteile hingewiesen, die sich insbesondere auf die Notwendigkeit zur Einhaltung eines engen Druckbereichs beziehen. Auch hier wird die Herstellung transparenter Schichten nicht erwähnt.

Der Erfindung liegt daher die Aufgabe zugrunde, ein Verfahren zur Herstellung von auch im sichtbaren Bereich transparenten, ungefärbten, diamantartigen Kohlenstoffschichten zu schaffen, die darüber hinaus eigenspannungsarm sind.

Zur Lösung dieser Aufgabe ist das erfindungsgemäße Verfahren dadurch gekennzeichnet, daß in einer sauerstofffreien Plasmaentladung abgeschieden wird, daß dem Arbeitsgas zusätzlich reiner Wasserstoff zugegeben wird, daß der Partialdruck des Kohlenwasserstoffgases zwischen $2 \times 10^{-3}$ mbar und 1 mbar eingestellt wird, daß das Verhältnis der Partialdrücke Kohlenwasserstoff : Wasserstoff zwischen 0,5 und 10 liegt, daß vor dem Einlassen der Arbeitsgase der Arbeitsdruck im Entladungsraum auf einen Druck kleiner als $2 \times 10^{-5}$ mbar eingestellt wird und daß die Plasmaentladung bei einer Spannung von 50 bis 600 Volt erfolgt.

Bevorzugt wird es, wenn die Plasmaentladung um das Substrat herum erzeugt wird, weil dadurch eine Rundumbeschichtung des betreffenden Substrats erfolgt.

Bei Durchführung des Verfahrens in Anwesenheit eines Edelgases, vorzugsweise Argon, liegt das Verhältnis der Partialdrücke Kohlenwasserstoff: Edelgas zwischen 0,1 und 10, vorzugsweise 1 und 5.

Die Beschichtung wird unter Vakuumbedingungen eingeleitet, nämlich bei einem Restgasdruck von weniger als $2 \times 10^{-5}$ mbar.

Die erfindungsgemäße Beschichtung wird durchgeführt, ohne daß ein vorhergehendes oder während der Beschichtung durchzuführendes Heizen des Substrats erforderlich ist. Vorzugsweise beträgt die Temperatur des Substrats 10 bis 20°C. Eine Kühlung bis auf −100°C ist möglich.

Die Plasmaentladung erfolgt mit niedrigen Spannungen, vorzugsweise 150 bis 250 Volt. Es wird eine Hochfrequenzanregung im Kilo- bis Megahertzbereich von 30 kHz bis 14 MHz zur Erzeugung und Aufrechterhaltung der Plasmaentladung benötigt.

Gemäß einer Variante des erfindungsgemäßen Verfahrens wird der Beschichtungsvorgang intermittierend durchgeführt. Während der zeitweiligen Unterbrechungen wird die Kohlenwasserstoffzufuhr unterbrochen, so daß das Substrat nur mit Edelgas und/oder Wasserstoff beschossen wird. Dabei kann der Partialdruck des Edelgases und/oder Wasserstoffs erhöht werden. Bei einer Gesamtdauer, die so gewählt wird, daß die gewünschte Schichtdicke erreicht wird, kann, z.B. jeweils 1 Sekunde bis 10 Minuten lang, vorzugsweise 2 Sekunden bis 2 Minuten lang, beschichtet und 1 Sekunde bis 10 Minuten, vorzugsweise 1 Sekunde bis 1 Minute lang die Kohlenwasserstoffzufuhr unterbrochen werden.

Als Kohlenwasserstoffe können beliebige gesättigte oder oder ungesättigte Kohlenwasserstoffe mit möglichst nicht mehr als 10 Kohlenstofatomen verwendet werden, z.B. Acetylen, Ethylen und dergleichen. Erfindungsgemäß wird reiner Wasserstoff eingesetzt und vorzugsweise reine Edelgase. Alle Arbeitsgase können in angegebener Zusammensetzung gemischt und anschließend eingelassen werden oder sie werden in den Entladungsraum einzeln zugeführt, wo sie sich vermischen.

Die Beschichtungsapparatur, z.B. eine Diodenanlage, Trioden- oder thermisch gestützte Triodenanlage, aber auch magnetfeldgestützte Anlagen, wird erfindungsgemäß möglichst auf einen Druck von kleiner als $2 \times 10^{-5}$ mbar evakuiert. Anschließend werden die Arbeitsgase im gewünschten Mischungsverhältnis eingelassen.

Das Verfahren wird dynamisch durchgeführt, d.h. die Gaszuführung wird so geregelt, daß bei laufender Vakuumpumpe der oben angegebene Arbeitsdruck erreicht wird. Nachdem der Arbeitsdruck eingeregelt ist, wird die Plasmaentladung gezündet, die bei geeigneter Prozeßführung homogen um das zu beschichtende Substrat brennt. Üblicherweise wird eine Hochfrequenzanregung zur Aufrechterhaltung der Plasmaentladung benutzt.

Die Arbeitsgase werden im Plasmaraum angeregt, dissoziiert und ionisiert. Durch die negative Vorspannung am in an sich bekannterweise vorgereinigten Substrat werden die Ionen aus dem Plasmaraum auf dieses gezogen. Sie treffen dort mit einer genügend hohen Energie auf, wodurch das Kristallgitter der Schicht zumindest teilweise Diamantstruktur erhält.

Durch die erfindungsgemäßen Maßnahmen lassen sich auch im sichtbaren Wellenlängenbereichtransparente und ungefärbte Schichten herstellen. Andererseits können größere Schichtdikken erzeugt werden, da die nach dem erfindungsgemäßen Verfahren abgeschiedenen Schichten geringere innere Spannungen besitzen. Die diamantartigen Kohlenstoffschichten zeigen auch eine große Härte von mehr als 3.500 HV, hohen spezifischen Widerstand von bis $10^{-5}\Omega cm$, einen niedrigen Reibungskoeffizienten vor allem im Vakuum, wodurch sie sich ebenfalls für Weltraumanwendungen hervorragend eignen. Darüber hinaus ermöglicht das erfindungsgemäße Verfahren eine große Aufwachsrate. Da die Substrate ohne Drehung im Vakuum allseitig beschichtet werden können, ist es möglich, große Stückzahlen während eines Vorganges gleichzeitig zu beschichten.

Die Erfindung wird in den nachfolgenden Beispielen näher beschrieben:

### Beispiel 1

Eine Glasscheibe von $5 \times 5$ cm Größe die als Substrat für, die Kohlenstoffschicht vorgesehen war, wurde in einem Ultraschallbad unter Verwendung von Lösungsmittel gereinigt, mit destilliertem Wasser gespült und anschließend in zwei Ultraaschallbädern mit Aceton und Methanol jeweils für 15 Minuten gereinigt.

Die Glasscheibe wurde dann in eine kommerzielle Beschichtungsanlage gegeben, die auf einen Restgasdruck von weniger als etwa $2 \times 10^{-5}$ mbar abgepumpt wurde, und mit einer Entladungsspannung von 400 V, unter Zugabe von Argon mit einem Partialdruck von $5 \times 10^{-3}$ mbar, 10 Minuten ionengeätzt. Danach wurde die Anlage auf oben angegebenen Druck evakuiert. In die Anlage eingelassen wurden folgende Gase bis zu den angegebenen Partialdrücken: Acetylen ($2 \times 10^{-3}$ mbar), Wasserstoff ($1 \times 10^{-3}$ mbar) und Argon ($3 \times 10^{-3}$ mbar). Die Entladungsspannung wurde auf 300 V eingestellt. Nach 25 Minuten Beschichtung wurde eine festhaftende, auch im sichtbaren Bereich transparente, ungefärbte 0,5 µm dicke, harte Schicht erhalten, die eine geringe Eigenspannung besaß.

### Beispiel 2

Ein zylindrischer Glaskörper mit einem Durchmesser von 3,5 mm und einer Länge von 25 mm wurde, wie im Beispiel 1 beschrieben, gereinigt. Nach dem Evakuieren der Beschichtungsanlage auf die im Beispiel 1 angegebenen Werte, wurden folgende Gase eingelassen: Ethylen ($3 \times 10^{-3}$ mbar) und Wasserstoff ($1 \times 10^{-3}$ mbar). Die Entladungsspannung betrug 150 Volt. Die Beschichtung- wurde 40 Minuten durchgeführt. Es wurde eine Schichtdicke von 3 µm erzielt. Die Schicht war gut haftend und sehr hart.

### Beispiel 3

Eine Edelstahlscheibe der Abmessungen $18 \times 18$ mm wurde nach dem Verfahren des Beispiels 1 gereinigt. Nach Abpumpen der Anlage wurden folgende Gase eingelassen: Acethylen ($8 \times 10^{-3}$ mbar), Wasserstoff ($8 \times 10^{-4}$ mbar) und Argon ($1 \times 10^{-3}$ mbar). Die Entladungsspannung betrug 200 Volt. Nach einer Beschichtungszeit von 10 Minuten wurde die Acetylen-Zufuhr für 2 Minuten abgeschaltet und der Partialdruck des Wasserstoffs auf $5 \times 10^{-3}$ mbar und der des Argons auf $8 \times 10^{-3}$ mbar erhöht. Dieser Vorgang wurde 15 mal wiederholt. Die Schichtdicke betrug 4,5 µm. Die Schicht war sehr hart und eigenspannungsfrei.

**Patentansprüche**

1. Verfahren zur Herstellung einer diamantartigen Kohlenstoffschicht, bei dem ein Arbeitsgas, enthaltend ein Kohlenwasserstoffgas oder eine Mischung von Kohlenwasserstoffgasen, ggf. in Anwesenheit eines Edelgases, durch eine beiniedriger Spannung brennende Plasmaentladung ionisiert wird, die durch eine Hochfrequenzanregung erzeugt wird, die von den zugeleiteten Gasen selbst getragen wird, wobei die Gase in der Plasmaentladung angeregt, dissoziiert, ionisiert und auf ein zu beschichtendes Substrat beschleunigt werden, wobei das Substrat höchstens auf Raumtemperatur gehalten wird, dadurch gekennzeichnet, daß in einer sauerstofffreien Plasmaentladung abgeschieden wird, daß dem Arbeitsgas zusätzlich reiner Wasserstoff zugegeben wird, daß der Partialdruck des Kohlenwasserstoffgases zwischen $2 \times 10^{-3}$ mbar und 1 mbar eingestellt wird, daß das Verhältnis der Partialdrücke Kohlenwasserstoff: Wasserstoff zwischen 0,5 und 10 liegt, daß vor dem Einlassen der Arbeitsgase der Arbeitsdruck im Entladungsraum auf einen Druck kleiner als $2 \times 10^{-5}$ mbar eingestellt wird und daß die Plasmaentladung bei einer Spannung von 50 bis 600 Volt erfolgt.

2. Verfahren nach Anspruch 1, dadurch gekennzeichnet, daß das Verhältnis der Partialdrücke Kohlenwasserstoff: Edelgas, vorzugsweise Argon, zwischen 0,1 und 10, vorzugsweise zwischen 1 und 5 beträgt.

3. Verfahren nach Anspruch 1 oder 2, dadurch gekennzeichnet, daß die Plasmaentladung um das Substrat herum erzeugt wird.

4. Verfahren nach einem der Ansprüche 1 bis 3, dadurch gekennzeichnet, daß das zu beschichtende Substrat bis auf −100°C, vorzugsweise auf 10°C bis 20°C, gekühlt wird.

5. Verfahren nach einem der Ansprüche 1 bis 4, dadurch gekennzeichnet, daß die Plasmaentladung bei einer Spannung von 150 bis 250 Volt durchgeführt wird.

6. Verfahren nach einem der Ansprüche 1 bis 5, dadurch gekennzeichnet, daß zur Plasmaentladung Frequenzen im Kilo- bis Megahertzbereich, vorzugsweise zwischen 30 KHz und 14 MHz, verwendet werden.

7. Verfahren nach einem der Ansprüche 1 bis 6, dadurch gekennzeichnet, daß der Beschichtungsvorgang intermittierend durchgeführt wird, wobei während den zeitweiligen Unterbrechungen des Beschichtungsvorganges die Zufuhr von Kohlenwasserstoffen unterbunden und damit das Substrat mit Edelgas und/oder Wasserstoff beschossen wird.

8. Verfahren nach Anspruch 7, dadurch gekennzeichnet, daß das Substrat 1 Sekunde bis 20 Minuten, vorzugsweise 2 Sekunden bis 2 Minuten, beschichtet, die Zufuhr von Kohlenwasserstoffen 1 Sekunde bis 10 Minuten, vorzugsweise 1 Sekunde bis 1 Minute, unterbrochen wird und dieses Verfahren bis zur Erzielung der gewünschten Schichtdicke wiederholt wird.

## Revendications

1. Procédé de fabrication d'une couche de carbone diamantine, dans laquelle un gaz de travail, contenant un gaz d'hydrocarbure ou un mélange de gaz d'hydrocarbures, le cas échéant en présence d'un gaz rare, est ionisé par une décharge de plasma, brûlant sous faible tension, qui est produite par une excitation à haute fréquence, qui est portée par les gaz amenés eux-mêmes, les gaz étant, dans la décharge de plasma, excités, dissociés, ionisés et accélérés sur un substrat à recouvrir, le substrat étant maintenu tout au plus à la température ambiante, caractérisé en ce qu'on effectue le dépôt par décharge de plasma en l'absence d'oxygène, que l'on ajoute de l'hydrogène pur au gaz de travail, que la pression partielle du gaz d'hydrocarbure est réglée entre $2 \times 10^{-3}$ mbar et 1 mbar, que le rapport entre les pressions partielles d'hydrocarbure et d'hydrogène est compris entre 0,5 et 10, qu'avant d'introduire les gaz de travail la pression de travail est réglée dans l'enceinte de décharge à une pression inférieure à $2 \times 10^{-5}$ mbar et que la décharge de plasma s'effectue à une tension allant de 50 à 600 Volt.

2. Procédé selon la revendication 1, caractérisé en ce que le rapport entre les pressions partielles d'hydrocarbure et de gaz rare, de préférence d'argon, est compris entre 0,1 et 10, de préférence entre 1 et 5.

3. Procédé selon la revendication 1 ou 2, caractérisé en ce que la décharge de plasma est produite tout autour du substrat.

4. Procédé selon l'une des revendications 1 à 3, caractérisé en ce que le substrat à recouvrir est refroidi jusqu'à −100°C, de préférence refroidi entre 10° et 20°C.

5. Procédé selon l'une des revendications 1 à 4, caractérisé en ce que la décharge de plasma est effectuée à une tension de 150 à 250 Volt.

6. Procédé selon l'une des revendications 1 à 5, caractérisé en ce que l'on utilise pour la décharge de plasma des fréquences situées dans la plage des kilohertz aux mégahertz, de préférence entre 30 KHz et 14 MHz.

7. Procédé selon l'une des revendications 1 à 6, caractérisé en ce que le processus de revêtement est de nature intermittente, l'amenée d'hydrocarbures étant stoppée pendant les interruptions temporaires et le substrat étant ainsi chargé avec un gaz rare et/ou de l'hydrogène.

8. Procédé selon la revendication 7, caractérisé en ce que le substrat est recouvert pendant 1 seconde à 2 minutes, de préférence pendant 2 secondes à 2 minutes, l'amenée d'hydrocarbures étant interrompue pendant 1 seconde à 10 minutes, de préférence 1 seconde à 1 minute, et ce processus étant répété jusqu'à l'obtention de l'épaisseur de couche souhaitée.

## Claims

1. Method of producing a diamond-like carbon coating, according to which an operating gas containing a hydrocarbon gas or a mixture of hydrocarbon gases, possibly in the presence of a noble gas, is ionised by plasma discharge taking place at low voltage, said plasma discharge being produced by high frequency excitation which is sustained by the gases admitted, the gases being excited, dissociated, ionised and accelerated toward a substrate to be coated during the plasma discharge, the substrate being kept at a temperature not exceeding room temperature, comprising: coating in an oxygen-free plasma discharge; adding pure hydrogen to the operating gas; adjusting the partial pressure of the hydrocarbon gas between $2 \times 10^{-3}$ mbar and 1 mbar; the ratio of the partial pressures of hydrocarbon: hydrogen being between 0.5 and 10; prior to admitting the operating gases, adjusting the operating pressure in the discharge space to a pressure smaller than $2 \times 10^{-5}$ mbar; and carrying out plasma discharge at a voltage of 50 to 600 V.

2. Method as claimed in Claim 1, wherein the ratio of the partial pressures of hydrocarbon: noble gas, preferably argon, ranges between 0.1 and 10, preferably between 1 and 5.

3. Method as claimed in Claim 1 or Claim 2, wherein plasma discharge is produced around the substrate.

4. Method as claimed in any of Claims 1 to 3, wherein the substrate to be coated is cooled down to −100°C, preferably to 10°C to 20°C.

5. Method as claimed in any of Claims 1 to 4, wherein plasma discharge is carried out at a voltage of 150 to 250 V.

6. Method as claimed in any of Claims 1 to 5, wherein frequencies in the kilohertz to megahertz range, preferably between 30 KHz and 14 MHz, are used for plasma discharge.

7. Method as claimed in any of Claims 1 to 6, wherein coating is carried out intermittently, during the temporary interruptions of the coating process the hydrocarbon supply being discontinued so that the substrate is bombarded with noble gas and/or hydrogen.

8. Method as claimed in Claim 7, wherein the substrate is coated during 1 second to 20 minutes, preferably 2 seconds to 2 minutes, the admission of hydrocarbons is interrupted during 1 second to 10 minutes, preferably 1 second to 1 minute, and this procedure is repeated until the desired film thickness has been achieved.